Europäisches Patentamt

**European Patent Office**

Office européen des brevets

(19)

(11) Numéro de publication: **0 078 189**
**B1**

(12) **FASCICULE DE BREVET EUROPEEN**

(45) Date de publication du fascicule du brevet:
**19.03.86**

(21) Numéro de dépôt: **82401857.6**

(22) Date de dépôt: **08.10.82**

(51) Int. Cl.⁴: **H 03 F 1/02,** H 03 F 3/19,
G 01 S 7/28

(54) Emetteur de puissance hyperfréquence à transistors à effet de champ, notamment pour radar Doppler.

(30) Priorité: **23.10.81 FR 8119940**

(43) Date de publication de la demande:
**04.05.83 Bulletin 83/18**

(45) Mention de la délivrance du brevet:
**19.03.86 Bulletin 86/12**

(84) Etats contractants désignés:
**CH DE GB IT LI NL SE**

(56) Documents cités:
**DE - A - 2 904 231**
**FR - A - 1 572 608**
**FR - A - 2 448 254**
**US - A - 3 483 425**
**US - A - 4 268 797**

(73) Titulaire: **LMT RADIO PROFESSIONNELLE, 46-47, Quai Alphonse Le Gallo, F-92103 Boulogne-Billancourt (FR)**

(72) Inventeur: **Marchand, Maurice,**
**THOMSON-CSF 173 Boulevard Haussmann,**
**F-75379 Paris Cedex 08 (FR)**
Inventeur: **Haentjens, Yan,**
**THOMSON-CSF 173 Boulevard Haussmann,**
**F-75379 Paris Cedex 08 (FR)**

(74) Mandataire: **Desperrier, Jean-Louis et al,**
**THOMSON-CSF SCPI 19, avenue de Messine,**
**F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1986

## Description

La présente invention se rapporte aux émetteurs hyperfréquences à transistors à effet de champ, qui permettent notamment de réaliser des radars du type Doppler complétement transistorisés, même dans les étages de puissance de l'émetteur. De tels radars Doppler sont en particulier utilisés pour la surveillance terrestre, et il est très important dans ce cas de réduire le poids, l'encombrement et la consommation. Le remplacement des tubes à vide par des transistors permet un gain important sur ces points.

Il est connu d'utiliser des transistors, notamment des transistors a effet de champ, pour amplifier les hyperfréquences, en particulier dans la bande dite 1 qui se situe aux alentours de 10 GHz. Ces transistors sont généralement réalisés en utilisant comme semiconducteurs de l'arséniure de gallium. Ils ne peuvent fonctionner qu'en classe A, d'où une consommation sensiblement constante, et un gaspillage d'énergie dans les temps morts constitués par les intervalles entre les impulsions hyperfréquences caractéristiques du radar. L'économie de consommation, que l'on pouvait espérer réaliser en utilisant de tels transistors, est ainsi fortement réduite par comparaison avec les tubes à vide, qui peuvent fonctionner en classe C et ne sont donc alimentés que pendant les impulsions d'émission.

On connaît d'après le document US-A-4 268 797 un émetteur de puissance hyperfréquence comportant dans ses étages de puissance des transistors à effet de champ fonctionnant en classe A, qui nécessitent une source de tension de polarisation négative.

Pour diminuer encore la consommation, l'invention propose un émetteur de puissance hyperfréquence à transistors à effet de champ,du type comprenant au moins un amplificateur de puissance (164) muni de transistors à effet de champ fonctionnant en classe A, dans lequel chacun des transistors à effet de champ est alimenté par son drain et dans lequel les signaux à amplifier sont appliqués sur sa grille, caractérisé en ce qu'il comporte des moyens (165) pour alimenter cet amplificateur par une tension d'alimentation régulée, et des moyens (123) pour commander la coupure de cette tension d'alimentation en dehors des instants d'émission du signal hyperfréquence.

D'autres particularités et avantages de l'invention apparaitront clairement dans la description suivante présentée à titre d'exemple non limitatif et faite en regard des figures annexées qui représentent:

- la figure 1, un schéma synoptique d'un émetteur selon l'invention;
- la figure 2, un schéma détaillé des organes 161, 123, et partiel de l'organe 165, de la figure 1;
- la figure 3, un schéma détaillé des organes 162 à 164, et partiel de l'organe 165, de la figure 1.

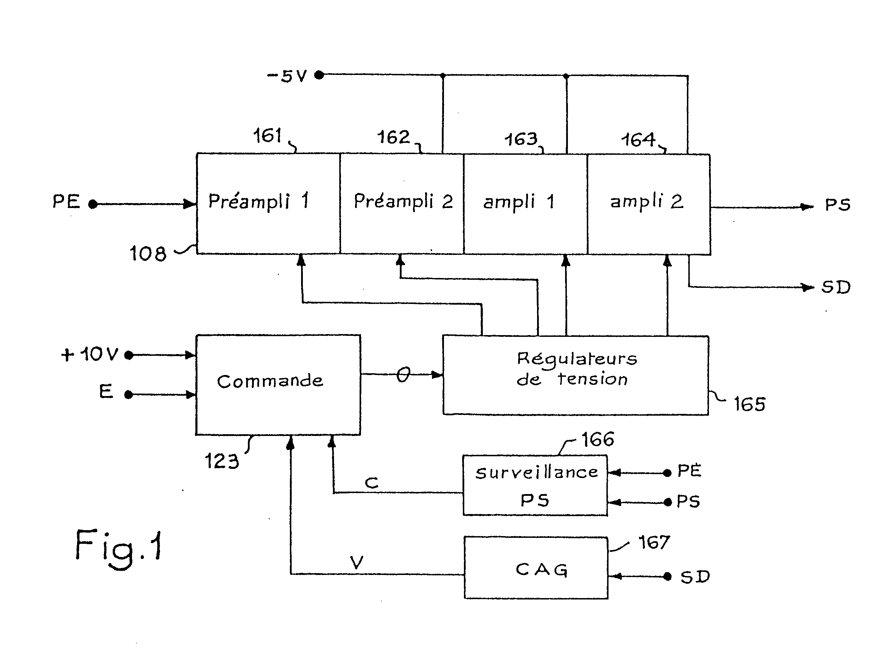

L'émetteur dont le schéma synoptique est représenté sur la figure 1, comprend des organes d'amplification disposés dans une structure hyperfréquence 108, et que l'on peut répartir entre un premier préamplificateur 161, un deuxième préamplificateur 162, un premier amplificateur 163 et un deuxième amplificateur de puissance final 164. Le signal à émettre PE est appliqué à l'entrée du préamplificateur 161. Il se présente sous la forme de trains d'impulsions hyperfréquences de faible niveau obtenus à partir d'un circuit de modulation alimenté par un synthétiseur par exemple. L'amplificateur final de puissance 164 délivre le signal d'émission PS, qui est le signal PE convenablement amplifie.

Les organes d'amplification contenus dans la structure 108 reçoivent d'une part une tension de polarisation, de - 5 volts dans cet exemple, et d'autre part une tension d'alimentation qui fournit la puissance nécessaire et qui est délivrée par un ensemble de régulateurs de tension 165. Ces régulateurs sont commandés par un circuit de commande 123 qui reçoit notamment une tension d'alimentation continue brute, de + 10 volts dans cet exemple.

Ce circuit de commande reçoit par ailleurs un certain nombre de signaux qui permettent de délivrer aux régulateurs de tension 165 des signaux de commande qui font varier les paramètres de ces régulateurs, afin d'alimenter les étages de l'amplificateur selon des modalités qui vont être décrites par la suite. Ces signaux de commande comprennent un signal numérique de modulation E comportant des créneaux qui encadrent les impulsions hyperfréquences de PE, un signal de coupure C, et un signal de commande analogique de modulation V.

Le signal de coupure C est issu d'un circuit de surveillance 166 du signal de sortie PS. Ce circuit contrôle les paramètres temporels du signal PS en les comparant aux paramètres temporels du signal PE. Il envoie un signal de coupure lorsqu'il détecte une différence qui excède une valeur déterminée.

Le signal de commande analogique V provient d'un circuit 167 de contrôle automatique de gain, qui réalise une simple adaptation de niveau entre un signal SD obtenu par redressement du signal PS dans l'étage de puissance 164, et le signal V nécessaire au circuit de commande 123.

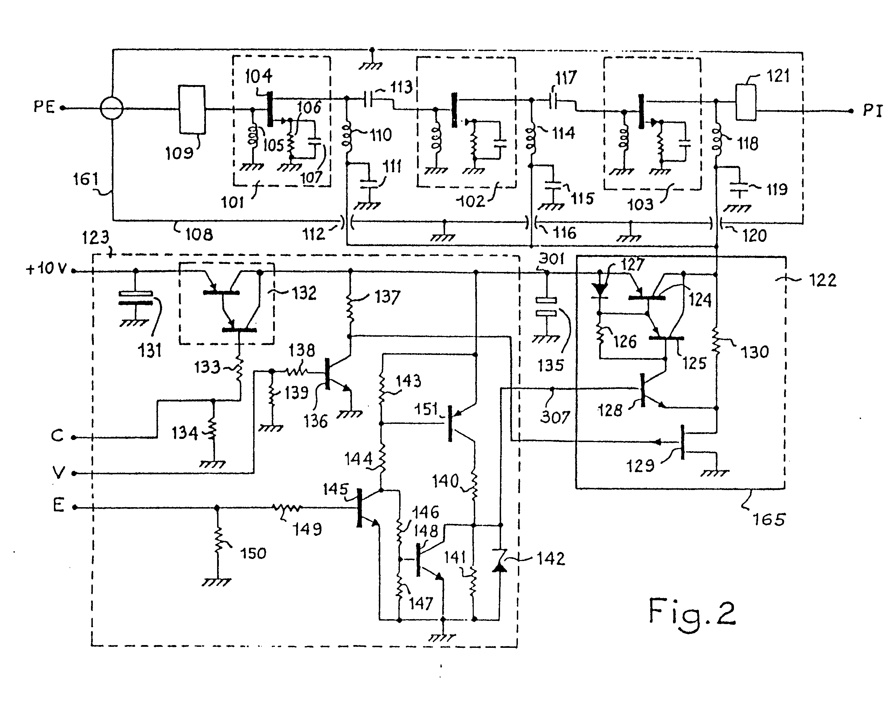

Le premier préamplificateur 161, ainsi que la partie des régulateurs de tension 165 qui lui correspond, et le circuit de commande 123, sont représentés sur la figure 2.

Le préamplificateur 161 utilise comme composants actifs hyperfrequence trois transistors à effet de champ 101 a 103. Ces transistors sont connus dans le commerce sous la reference THC 9311-9312 et comportent en fait dans un boîtier un transistor à l'arséniure de galium tel que 104 qui est muni d'éléments permettant une préadaptation et une autopolarisation. Ces éléments comportent une inductance de choc 105 qui relie la grille du transistor à la masse au point de vue continu, et une résistance de polarisation 106 qui relie la source à la masse et qui est shuntée par un condensateur de découplage 107. Ces éléments, ainsi que les conducteurs reliant le transistor aux bornes de sortie du boîtier dans lequel il est livré, permettent un montage très simple, puisqu'il ne nécessite aucun élément externe de polarisation, et un minimum d'éléments externes d'adaptation aux circuits dans lesquels il est monte.

Ces trois transistors sont montés dans la structure hyperfréquence 108, formée selon une technique connue par un bloc métallique dans lequel sont creusées des cavités recevant les différents organes, en isolant les étages entre-eux pour ne permettre la liaison que par des connexions transversant les parois situées entre ces cavités par des orifices adéquats.

Le premier étage d'amplification est attaqué par le signal d'entrée PE qui est appliqué sur la grille du premier transistor 101 par un circuit d'adaptation 109, qui n'est pas représenté en détail sur la figure caril comporte essentiellement, de manière connue dans l'art, un transformateur d'impédance permettant d'adapter l'impédance relativement faible de la grille du transistor à celle plus importante des circuits extérieurs qui attaquent le transistor, et dont la valeur est, selon une pratique courante en hyperfréquence, par exemple de 50 ohms.

La résistance de source du transistor 101 est reliée à la masse de la structure 108, et son drain est alimenté en courant continu par l'intermédiaire d'une inductance de charge 110 découplée à la masse par un condensateur de découplage 111 et par un condensateur de by-pass 112 L'inductance 110 est représentée pour les besoins du dessin sous la forme d'une bobine, mais compte tenu des fréquences utilisées elle est bien entendu sous la forme d'une ligne à constantes réparties, ainsi que les autres inductances du circuit.

La sortie de ce premier étage est prise sur le drain du transistor 101 et est reliée à la grille du transistor 102 qui forme le deuxième étage par l'intermédiaire d'un condensateur de liaison 113.

Ce deuxième étage est connecté de la même manière que le premier par une inductance de charge 114, un condensateur de découplage 115, et un condensateur de by-pass 116 Il est relie au troisième etage par un condensateur de liaison 117.

Ce troisième étage est lui-même alimenté par une inductance de charge 118, un condensateur de découplage 119 et un condensateur de bypass 120.

La sortie du préamplificateur est prise sur le drain du transistor 103 par l'intermédiaire d'un circuit d'adaptation 121 non précisé sur le dessin pour la simplicité, mais d'une technique courante en hyperfréquence comme le circuit 109. Ce circuit d'adaptation délivre un signal de sortie PI.

Les trois étages d'amplification hyperfréquence sont alimentés par le régulateur de tension 122 qui fait partir du groupe de régulateurs 165 et est commandé par le circuit de commande 123.

Le régulateur comporte un transistor ballast 124 dont l'émetteur reçoit la tension d'alimentation positive de 10 volts du circuit de commande 123, et dont le collecteur délivre la tension d'alimentation régulée aux trois impédances de charge 110, 114 et 118.

Le transistor 124 est connecté selon le montage Darlington à l'aide d'un transistor 125 dont l'émetteur est reuni à la base par une résistance 126.

L'émetteur du transistor 124 est réuni à sa propre base par une diode de polarisation 127.

La base du transistor 125 est reliée également au collecteur d'un transistor 128 dont l'émetteur est relié à la masse par l'intermédiaire du circuit drain-source d'un transistor à effet de champ 129.

La base du transistor 128 reçoit une tension de référence, et la grille du transistor 129 une tension de commande.

L'émetteur du transistor 128 est également réuni au collecteur du transistor 124 par une résistance 130.

Le montage ainsi réalisé constitue un régulateur relativement classique, mais dont la tension de sortie est réglable en agissant par la tension de commande appliquée sur la grille du transistor 129, lequel agit en résistance variable. D'autre part on peut, en supprimant ou en établissant la tension de référence, couper ou établir la tension desortie du régulateur dans un délai extrêmement rapide qui ne dépasse pas quelques dizaines de nanosecondes, si la vitesse de coupure ou d'établissement de cette tension de référence est suffisante bien entendu.

Le circuit de commande comporte un condensateur de filtrage 131 qui est alimenté par la tension non régulée de 10 volts. Ce condensateur de filtrage est reilé à l'entrée d'alimentation du régulateur 122 par l'intermédiaire d'un transistor 132 du type Darlington intégré. La basedu transistor 132 est reilée à la masse par des résistances 133 et 134 en série.

Le point commun de ces deux résistances est réuni à une connexion d'entrée du circuit de commande qui peut recevoir le signal de coupure C lequel permet de bloquer le transistor 132, et par là même de couper l'alimentation du préamplificateur lors de la détection d'un défaut, par exemple à l'aide d'un circuit extérieur.

La connexion d'alimentation entre les circuits 122 et 123 est d'autre part shuntée à la masse par un condensateur 135 reilé à cette connexion en un point 301, qui permet de filtrer la tension de sortie du circuit 123.

Le circuit de commande 123 comprend également un transistor 136 alimenté à partir de la sortie du transistor 132 par une resistance 137 reliée à son collecteur. Son émetteur et sa base sont reliés a la masse, directement pour l'émetteur, et par l'intermédiaire de deux résistances 138 et 139 en série pour la base.

Le point commun de ces deux résistances 138 et 139 est relié à une connexion d'entrée du circuit de commande 123, qui peut recevoir le signal de commande analogique V. Ce signal est donc amplifié par le transistor 136 et se retrouve avec la phase inverse et un niveau adéquat sur le collecteur de ce dernier. Il est alors appliqué depuis ce collecteurà la grille du transistor à effet de champ 129 du régulateur 122. La résistance présentée par le circuit drain-source de ce transistor 129 varie donc en fonction des variations du signal de commande V. Ceci permet de faire varier la tension d'alimentation des étages d'amplification selon les variations de ce signal V.

En effet dans ce montage, utilisant notamment les transistors hyperfréquences cités plus haut, le taux d'onde stationnaire de l'ensemble varie très peu àvec la tension d'alimentation alors que le gain varie d'une façon très significative.

Ceci permet de moduler le signal PI de façon tout à fait simple et pratiquement sans désadapter l'étage.

Le signal de coupure C permet de supprimer l'alimentation totale du dispositif, en cas par exemple de détection d'un mauvais fonctionnement dans le circuit de surveillance 166, comme par exemple la disparition des impulsions dans PS. La rapidité de cette coupure n'est pas très grande, en raison notamment du condensateur de filtrage 135. Pour pouvoir alors moduler le préamplificateur par tout ou rien, et le faire fonctionner en impulsions alors que la modulation due au signal V conservait le fonctionnement en ondes entretenues, le circuit de commande comprend en outre des moyens permettant d'appliquer sur la base du transistor 128 une tension de référence pouvant être coupée à partir du signal de commande numérique E.

Ces moyens comprennent un transistor 151 dont l'émetteur est alimenté à partir du collecteur du transistor 132 et dont le collecteur est relié à la masse par deux résistances 140 et 141 en série. La résistance 141 est shuntée par une diode Zener 142 qui fournit une tension stabilisée de référence à la base du transistor 128 via une connexion 307. La base du transistor 151 est reliée à son émetteur par une résistance 143 et au collecteur d'un transistor 145 par une résistance 144. L'émetteur et le collecteur du transistor 145 sont reliés à la masse, le premier directement, et le second par deux résistances 146 et 147 en série. La connexion commune à ces deux résistances est reliée à labase d'un transistor 148 dont l'émetteur est à la masse et le collecteur relié à la cathode de la diode 142.

La base du transistor 145 est reliée à la masse par deux résistances 149 et 150 en série.

Le signal numérique de commande E est appliqué à une borne d'entrée du circuit 123 qui est reliée au point commun aux résistances149 et 150.

Ainsi un signal numérique de commande, compatible par exemple avec des circuits TTL, appliqué sur cette entrée E, fait varier la tension de référence appilquée au régulateur 122 entre une valeur nulle et la valeur de référence proprement dite en reproduisant les variations de ce signal numérique. Le préamplificateur fonctionne ainsi en impulsions, mais le signal à l'intérieur de ces impulsions demeure en classe A.

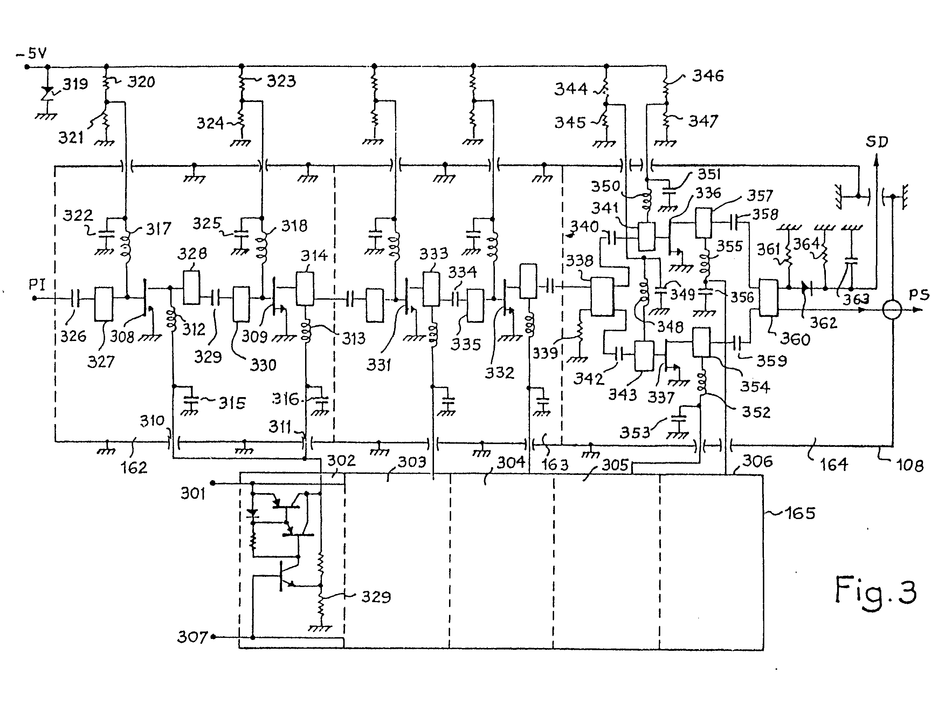

Le signal PI en sortie du préampilficateur 161 est appliqué à l'entrée du deuxième préamplificateur 162 représenté avec son régulateur de tension 302 sur la figure 3.

Ce deuxième préamplificateur est muni de deux transistors 308 et 309 en série. Le premier transistor 308 permet de délivrer une puissance de 60 milliwatts, avec une tension drain-source de 8 volts et une intensité drain de 60 milliampères. Le deuxième transistor 309 permet de délivrer une puissance de 200 milliwatts, avec une intensité drain de 100 milliampères et la même tension drain-source de 8 volts, qui est d'ailleurs commune à l'ensemble des transistors des quatres étages 162 à 164.

Cette tension est appliquée à partir du régulateur 302, qui fait partie de l'ensemble des régulateurs 165, par des connexions qui penetrent dans la structure hyperfréquence 108 par des condensateurs du type bypass 310 et 311. Elle est appilquée au drain du transistor 308 par l'intermédiaire d'une inductance 312, et au drain du transistor 309 par l'intermédiaire d'un inductance 313 en série avec un circuit d'adaptation 314, qui n'est pas décrit plus avant pour des besoins de clarté et parce qu'il est d'une technique tout à fait courante dans l'art. Ces deux inductances sont découplées à la masse par des condensateurs de découplage 315 et 316.

Les grilles des transistors sont polarisées par des tensions prises sur des ponts de résistances alimentés à partir de la tension de polarisation négative - 5 volts, elle-même stabilisée par une diode Zener 319. Un pont formé des deux résistances en série 320 et 321 alimente la grille du transistor 308 par intermédiaire d'une inductance de choc 317 découpléeà la masse par une capacité 322. De même un pont forme de deux résistances en série 323 et 324 alimente la grille du transistor 309 par l'intermédiaire d'une inductance de choc 318 découplée à la masse parun condensateur 325. Les valeurs des résistances des ponts sont déterminées pour polariser les grilles de telle manière que les transistors débitentdes courants correspondant à l'intensité citée plus haut.

Le signal PI en sortie du premier préamplificateur 161 est appliqué à la grille du transistor 308 par un condensateur de liaison 326 en série avec un circuit d'adaptation d'impédance 327.

Le signal amplifié par le transistor 308 est appliqué à la grille du transistor 309 par l'intermédiaire d'un circuit d'adaptation d'impédance 328, puis d'un condensateur de liaison 329 et d'un autre circuit d'adaptation d'impédance 330.

Le circuit d'adaptation d'impédance 314 permet d'extraire le signal de sortie du deuxième préamplificateur 162 sur le drain du transistor 309.

Le signal ainsi obtenu est appliqué au premier amplificateur 163 comportant deux transistors 331 et 332 en cascade. Le transistor 331 permet de porter la puissance du signal à 400 milliwatts avec une intensité drain de 200 milliampères, et le transistor 332 porte cette puissance à 1 watt avec une intensité drain de 500 milliampères. Le schéma de cet étageest tout à fait semblable à celui du précédent et sa description sera limitée aux differences.

Une première différence réside dans le circuit d'adaptation d'impedance 333 qui relie le drain du transistor 331 à la grille du transistor 332 par l'intermédiaire d'un condensateur de liaison 334 et d'un autre circuit d'adaptation d'impédance 335. Contrairement au circuit d'adaptation 328 du premier transistor du deuxième préamplificateur, qui est du type dipôle, ce circuit d'adaptation 333 est du type quadripôle et donc semblable au circuit 314. Par ailleurs l'alimentation de transistor se fait de manière séparée à partir de deux régulateurs 303 et 304, en raison de la puissance mise en oeuvre et pour éliminer tout risque de couplage au niveau de l'alimentation.

Pour obtenir la puissance voulue de 2 watts pour le signal de sortie PS, on a utilisé deux transistors 336 et 337 du même type que le transistor 332 mais connectés en parallèle et débitant chacun 1 watt avec une intensité drain de 500 milliampère.

Pour appliquer des signaux convenables sur les grilles de ces transistors, le signal en sortie du premier amplificateur 163 est divisé en deux parties déphasées de 90 degrés par un déphaseur 338 de type courant en hyperfréquences, dont une entrée est reliée à la sortie de l'amplificateur 163 et l'autre entrée à la massae par une résistance d'équilibrage 339.

Les signaux ainsi obtenus sur les deux sorties de ce déphaseur sont appliqueés l'un sur lagrille du transistor 336 par un condensateur de découplage 340 en série avec un circuit d'adaption d'impédance 341, et l'autre sur la grille du transistor 337 par un condensateur de liaison 342 en série avec un circuit d'adaption 343.

Par ailleurs la grille du transistor 337 est polarisée depuis un pont de résistances 344, 345 alimenté par le - 5 volts, par l'intermédiaire d'une inductance de choc 348 alimentant le circuit d'adaptattion d'impédance 343. Cette inductance est découplée à la masse par un condensateur de découplage 349.

De même la grille du transistor 336 est polarisée par un pont de résistances 346, 347, une inductance de choc 350 et un condensateur de découplage 351.

Le drain du transistor 337 est alimenté à partir d'un régulateur de tension 305 par une inductance de choc 352 et un circuit d'adaption d'impédance 354. Cette inductance 352 est découplée par un condensateur 353. Le circuit est bouclé par la source du transistor 337 qui est à la masse. De même le transistor 336 est alimenté par un dernier régulateur de tension 306 et par l'intermédiaire d'une inductance de choc 355, d'un condensateur de découplage 356, et d'un circuit d'adaption d'impédance 357.

Les signaux en sortie des deux circuits de couplage 354 et 357 sont appliqués, par l'intermédiaire de deux condensateurs de liaison 358 et 359, sur l'entrée d'un circuit de recombinaison 360, connu dans l'art, qui fonctionne à l'inverse du déphaseur 338 et lui est très semblable. L'une des sorties de ce circuit délivre le signal PS desiré sous une puissance de 2 watts et l'autre sortie est bouclée à la masse par une résistance d'équilibrage 361. Afin d'obtenir une indication de la puissance de sortie, qui permette par l'intermédiaire du circuit de commande automatique de gain 167 de délivrer le signal de commande analogique qui, par l'intermédiaire du circuit de commande 123, permet de commander les régulateurs de tension 165 et de réguler ainsi la puissance de sortie à la valeur nominale, les signaux sur la sortie du circuit 360 reliée à la résistance 361 sont redressés par une diode 362 qui charge un condensateur 363, relié d'autre part à la masse et shunté par une résistance 364. On obtient ainsi surla cathode de la diode 362 le signal SD qui indique la puissance de sortie de l'émetteur.

Les régulateurs 302 à 306 sont idendiques entre eux et seul le schéma du régulateur 302 a été représenté. Comme ce schéma est identique à celui du régulateur 122 à l'exception d'un élément, seul ce dernier a été référencé sur la figure. En effet, comme il n'est pas nécessaire de moduler de manière analogique la tension appliquée aux étages de puissance formés du deuxième préamplificateur 162 et des amplificateurs 163 et 164, le transistor à effet de champ 129 fonctionnant en résistance variable à partir du signal de modulation analogique V a été remplacé par une resistance 329 de valeur fixe prevue pour que la tension en sortie du régulateur soit de 8 volts.

Le régulateur reçoit la tension à reguler à partir du point 301, et sa tension de référence à partir de la connexion 307 connectée à la cathode de la diode Zener 142.

Avec ce dispositif on peut ainsi alimenter tous les transistors de l'émetteur de puissance hyperfréquence avec une tension qui n'est présente qu'au moment nécessaire, c'est-à-dire pendant la durée des impulsions hyperfréquences. Pendant l'émission de ces impulsions les transistors fonctionnent en classe A, ce qui est nécessaire, mais en dehors de cellesci l'émetteur de puissance est coupé et il ne consomme qu'une puissance extrémement réduite correspondant au maintien des diverses polarisations. C'est ainsi que dans l'exemple de réalisation décrit on a pu obtenir une puissance de sortie de 2 watts entre 9,3 et 9,9 GHz pour des impulsions de récurrence de 4 kHz donc le taux de remplissage varie de 1 millième, soit une impulsion de 250 ns, à 6 centièmes, soit une impulsion de 15 μs.

## Revendications

1. Emetteur de puissance hyperfréquence a transistors a effet de champ, du type comprenant au moins un amplificateur de puissance (164 Fig3) muni de transistors à effet de champ fonctionnant en classe A, dans lequel chacun des transistors à effet de champ est alimenté par son drain, et dans lequel les signaux à amplifier sont appliques sur sa grille, caractérisé par le fait qu'il comprend en outre des moyens (165 Fig 3) pour alimenter cet amplificateur par une tension d'alimentation régulée, et des moyens (123Fig 1) pour commander la coupure de cette tension d'alimentation en dehors des instants d'émission du signal hyperfréquence.

2. Emetteur selon la revendication 1, caractérisé en ce que les moyens d'alimentation comprennent un régulateur (306 Fig 3) muni d'une entrée (307) permettant de lui appliquer une tension de référence, et que les moyens de commande (123 Fig 2) comprennent une diode Zener (142 Fig 2) permettant de delivrer cette tension de reference, et des moyens (140-151 Fig 2) pour alimenter cette diode Zener sous la commande d'un signal numérique de modulation.

3. Emetteur selon la revendication 2, caractérisé en ce que les moyens de commande comportent en outre des moyens (131-134 Fig 2) pour alimenter le régulateur avec une tension à reguler; ces moyens permettant en outre de supprimer cette tension sous la commande d'un signal de coupure.

4. Emetteur selon l'une quelconque des revendications 1 à 3, caractérisé en ce qu'il comprend en outre un préamplificateur (161 Fig2) dont le gain varie en fonction de la tension d'alimentation, un regulateur de tension variable (122 Fig 2)pour fournir cette tension d'alimentation au preamplificateur, et des moyens (136-139 Fig 2) pour commander ce régulateur sous la commande d'un signal analogique de modulation.

5. Emetteur selon la revendication 4, caractérisé en ce qu'il comprend en outre des moyens (361-364 Fig 3) pour mesurer l'amplitude du signal de sortie de l'émetteur, et des moyens de contrôle automatique de gain (167 Fig 1) pour élaborer le signal analogique de modulation en fonction de cette amplitude, ce qui stabilise le niveau de sortie de l'émetteur.

6. Emetteur selon l'une quelconque des revendications 1 à 5, caractérisé en ce qu'il comprend en outre des moyens (166 Fig 1) pour surveiller le signal de sortie et le comparer au signal d'entrée, et des moyens (132-134 Fig 2) pour couper la tension à réguler appliquée au régulateurde tension (165 Fig 2) alimente les étages d'amplification lorsque les caractéristiques du signal de sortie sortent de limite prédéterminée.

7. Emetteur selon l'une quelconque de revendications 1 à 6, caractérisé en ce qu'il comprend un premier préamplificateur (161 Fig 2) muni detrois transistors connectes en cascade, un deuxieme preamplificateur (162 Fig 1,3)connecté au premier préamplificateur et muni de deux transistors connectés en cascade, un premier amplificateur de puissance (163 Fig 1,3) connecté au deuxième préamplificateur et muni de deux transistors connectés en cascade, et un deuxième amplificateur de puissance formant étage final (164 Fig 1,3), et muni de deux transistors connectes en parallèle.

8. Emetteur selon la revendication 7, caractérisé en ce qu'il comprend un premier régulateur (122, Fig 2) de tension pour alimenter le premier preamplificateur, un deuxieme régulateur de tension (302 Fig 3) pour alimenter le deuxième préamplificateur, un troisième (303) et un quatrieme (304 Fig 3) régulateurs de tension pour alimenter respectivement les deux transistors du premier amplificateur de puissance, et un cinquième (305 Fig 3) et un sixieme (306 Fig 3) régulateurs de tension pour alimenter séparement lesdeux transistors du deuxième amplificateur de puissance.

**Patentansprüche**

1. Mikrowellen-Leistungssender mit Feldeffekttransistoren, vom Typ mit wenigstens einem Leistungsverstärker (164), der mit im A-Betrieb arbeitenden Feldeffekttransistoren ausgerüstet ist, bei welchem jeder der Feldeffekttransistoren über seine Drain-Elektrode gespeist ist und worin die zu verstärkenden Signale an ihr Gate angelegt werden, dadurch gekennzeichnet, daß er ferner Mittel (165) zur Speisung dieses Verstärkers mit einer geregelten Versorgungsspannung sowie Mittel zur Steuerung des Abschaltens dieser Versorgungsspannung außerha1b der Mikrowellensignal-Sendemomente umfaßt.

2. Sender nach Anspruch 1, dadurch gekennzeichnet, daß die Versorgungsmittel einen Regler (306) umfassen, welcher mit einem Eingang (307) zum Anlegen einer Referenzspannung versehen ist, und daß die Steuermittel eine Zenerdiode (142) zum Abgeben dieser Referenzspannung umfassen und Mittel (140-151) zur Versorgung dieser Zenerdiode unter Steuerung durch ein digitales Modulationssignal enthalten.

3. Sender nach Anspruch 2, dadurch gekennzeichnet, daß die Steuermittel ferner Mittel (131-134) zur Versorgung des Reglers mit einer zu regelnden Spannung umfassen; wobei diese Mittel ferner die Unterdrückungdieser Spannung unter Steuerung durch ein Schaltsignal ermöglichen.

4. Sender nach einem der Ansprüche 1 bis 3, dadurch gekennzeichnet, daß er ferner einen Vorverstärker (161) umfaßt, dessen Verstärkung in Abhängigkeit von der Versorgungsspannung veränderlich ist, einen Regler (122) zur Einstellung einer variablen Spannung für die Versorgung des Vorverstärkers enthält sowie Mittel (136-139) zur Steuerung dieses Reglers unter der Steuerung durch ein analoges Modulationssignal umfaßt.

5. Sender nach Anspruch 4, dadurch gekennzeichnet, daß er ferner Mittel (361-364) zum Messen der Amplitude des Ausgangssignals des Senders sowie automatische Verstärkungsregelmittel (167) zur Erzeugung des analogen Modulationssignals in Abhängigkeit von dieser Amplitude umfaßt, wodurch der Ausgangspegel des Senders stabilisiert wird.

6. Sender nach einem der Ansprüche 1 bis 5, dadurch gekennzeichnet, daß er ferner Mittel (166) zur Überwachung des Ausgangssignals und zum Vergleichen desselben mit dem Eingangssignal und Mittel (132-134) umfaßt, um die zu regelnde Spannung abzuschalten, welche an den Spannungsregeler (165) angelegt ist, der die Verstärkerstufen speist, wenn die Kenndaten des Ausgangssignals außerhalb von vorbestimmten Grenzen liegen:

7. Sender nach einem der Ansprüche 1 bis 6, dadurch gekennzeichnet, daß er einen ersten Vorverstärker (161) mit drei in Kaskade geschalteten Transistoren, einen zweiten Vorverstärker (162), der mit dem ersten Vorverstärker verbunden und mit zwei in Kaskade geschalteten Transistoren versehen ist, einen ersten, an den zweiten Vorverstärker angeschlossenen Leistungsverstärker (163), der mit zwei in Kaskade geschalteten Transistoren versehen ist, und einen zweiten Leistungsverstärker enthält, der die Endstufe (164) bildet und mit zwei parallel geschalteten Transistoren versehen ist.

8. Sender nach Anspruch 7, dadurch gekennzeichnet, daß er einen ersten Spannungsregler zur Versorgung des ersten Vorverstärkers, einen zweiten Spannungsregler (302) zur Versorgung des zweiten Vorverstärkers, einen dritten (303) sowie einen vierten (304) Spannungsregler zur Versorgung je eines der zwei Transistoren des ersten Leistungsverstärkers und einen fünften (305) sowie einen sechsten (306) Spannungsregler zur getrennten Versorgung der beiden Transistoren des zweiten Leistungsverstärkers umfaßt.

**Claims**

1. Hyperfrequency power transmitter equipped with field effect transistors, of the type comprising at least one power amplifier (164) provided with field effect transistors operating in class A, wherein each of the field effect transistors is supplied by its drain and wherein the signals to be amplified are applied to its gate, characterized by the fact that it further comprises means (165) for supplying this amplifier with a controlled supply voltage and means for controlling the switching off of this supply voltage out of the transmission moments of the hyperfrequency signal.

2. Transmitter according to claim 1, characterized in that the supply means comprise a controller (306) provided with an input (307) for applying a reference voltage and in that the control means comprise a Zener diode (142) for supplying this reference voltage and means (140-151) for feeding this Zener diode under control of a digital modulation signal.

3. Transmitter according to claim 2, characterized in that the control means further comprise means (131-134) for feeding the controller with a voltage to be controlled; these means further permitting to eliminate this voltage under the control of a cutoff signal.

4. Transmitter according to any of claims 1 to 3, characterized in that it further comprises a preamplifier (161) the gain of which varies as a function of the supply voltage, a variable voltage controller (122) for supplying this supply voltage to the preamplifier and means (136-139) for controlling this controller under the control of an analog modulation signal.

5. Transmitter according to claim 4, characterized in that it further comprises means (361-364) for measuring the amplitude of the output signal of the transmitter and automatic gain control means (167) for generating the analog modulation signal as a function of this amplitude, whereby the output level of the transmitter is stabilized.

6. Transmitter according to any of claims 1 to 5, characterized in that it further comprises means (166) for monitoring the output signal and comparing it to the input signal, and means (132-134) for switching off the voltage to be controlled which is applied to the voltage controller (165) supplying the amplifier stages when the characteristics of the output signal exceed predetermined limits.

7. Transmitter according to any of claims 1 to 6, characterized in that it comprises a first preamplifier (161) equipped with three cascade connected transistors, a second preamplifier (162) connected to the first preamplifier and equipped with two cascade connected transistors, a first power amplifier (163) connected to the second preamplifier and equipped with two cascade connected transistors and a second power amplifier forming the final stage (164) and equipped with two parallel connected transistors.

8. Transmitter according to claim 7, characterized in that it comprises a first voltage controller for supplying the first preamplifier, a second voltage controller (302) for supplying the second preamplifier, third (303) and fourth (304) voltage controllers for supplying the two transistors of the first power amplifier, respectively, and fifth (305) and sixth (306) voltage controllers for separately supplying the two transistors of the second power amplifier.

Fig.1

Fig.2

Fig. 3